# EUROPEAN PATENT SPECIFICATION

(11) **EP 4 204 830 B1**
(45) Date of publication and mention of the grant of the patent: **04.11.2026**
(21) Application number: 21860783.6
(22) Date of filing: 26.08.2021
(51) Int. Cl.: G01R 31/367, G01R 31/387, G01R 31/389, G01R 31/392, G01R 31/396

(54) **A METHOD FOR ESTIMATING STATE OF CHARGE AND STATE OF HEALTH OF A BATTERY AND A SYSTEM THEREOF**
VERFAHREN ZUR SCHÄTZUNG DES LADEZUSTANDS UND DES GESUNDHEITSZUSTANDS EINER BATTERIE UND SYSTEM DAFÜR
PROCÉDÉ D'ESTIMATION D'UN ÉTAT DE CHARGE ET D'UN ÉTAT DE SANTÉ D'UNE BATTERIE ET SYSTÈME ASSOCIÉ

(30) Priority: 28.08.2020 IN 202021037245
(43) Date of publication of application: 05.07.2023
(73) Proprietor: Sedemac Mechatronics PVT Ltd, Maharashtra PIN 400069 (IN)
(72) Inventor: PABBU, Suraj Kumar, Telangana Karimnagar 505468 (IN); WADEGAONKAR, Amey P., Camp, Maharashtra Amravati 444602 (IN); JOSHI, Anaykumar, Dharampeth Maharashtra Nagpur 440010 (IN)
(74) Representative: Barker Brettell LLP
(86) International application number: PCT/IN2021/050823
(87) International publication number: WO 2022/044046

(56) References cited:
- US-A1- 2017 356 964
- US-A1- 2018 313 904
- US-A1- 2019 049 518
- US-B2- 10 267 861
- US-B2- 10 663 525
- US-B2- 8 937 459

## Description

### FIELD OF THE INVENTION

The present invention relates to estimating state of charge and state of health of a battery.

### BACKGROUND OF THE INVENTION

Modern electric vehicles and hybrid electric vehicles typically use electrochemical cells, such as lithium-ion cells, as energy storage units. Plurality of such cells configured in an appropriate series and parallel combination form a battery. Such batteries are typically coupled to a Battery Management System (BMS), with the BMS configured to monitor the cell voltages, current and temperatures, measured using suitable sensors. One of the primary functions of the BMS is to estimate the state of charge (SOC) and state of health (SOH) of the battery and its constituent cells. Another important function of the BMS is to ensure that the battery operates in a predetermined "Safe Operating Area" - such as to avoid conditions of cell overcharge, undercharge, overtemperature etc. Safe operating area of a cell in general imposes upper and lower thresholds on cell operating voltage, temperature, and current flowing through the cell. The battery is said to be operating in "Safe Operating Area" only if every cell is in "Safe Operating Area". Other important functions of a battery management system include balancing the charge among the cells to prolong the battery life and communicating information to other controllers in the vehicle network.

An accurate state of charge prediction is required to determine the remaining energy in the battery and to determine duration for which the battery can be operated based on present load condition. State of charge of a battery also provides a good judgement to the rider to schedule recharge of the battery. While the state of charge of battery is considered as short-term battery parameter, the state of health is considered as a long-term parameter since the battery degradation happens gradually over its lifetime. SOH of a battery is typically characterized by the total charge storage capacity of the battery. Another parameter that is used to characterize SOH is internal impedance of the battery which plays a major role in the available output power of the battery. An accurate health prediction improves the accuracy of SOC estimation since the latter depends on battery model parameters. Health prediction also provides information about degradation of the battery and aids to schedule replacement of the battery.

One of the conventional methods to estimate SOC is to integrate the current passing through the battery over time. However, this method is prone to drifting because of current measurement noise and measurement offset error. Another conventional method to estimate SOC is to leverage the known monotonic relationship between SOC and open circuit cell voltage of the battery. However, this method requires the battery to be in a relaxed condition, with no current flowing through the battery for a substantial amount of time. More accurate SOC and SOH estimation methods leverage an accurate equivalent model of the battery. Two broad categories of battery models are prevalent - the first category is the "Equivalent Circuit Model", which approximates the underlying chemical phenomenon in battery with an equivalent resistor-capacitor network. Examples of Equivalent Circuit models are series resistance model, 1RC equivalent circuit, 2RC equivalent circuit. The second category is the "Electro-Chemical Model" such as DFN (Doyle-Fuller-Newman) model, SPM (Single Particle Model). Electro-Chemical models are computationally intensive because of the underlying complexity in modelling, and are thus not commonly used in practical BMS systems. In general, Equivalent Circuit models are less accurate than Electro-Chemical models but are more suitable for implementation in practical BMS. US 2017/356964 (A1) discloses an automatic estimation procedure for estimating a battery's state-of-charge, which includes predicting the state-of-charge using a state model that includes a state-transition matrix. An observation model then uses an observability matrix in connection with predicting a measured value of a parameter. State noise, the covariance of which is characterised by a state-noise covariance matrix contaminates this prediction. Similarly, measurement noise, the covariance of which is characterised by a measurement covariance matrix, contaminates this prediction. The values of these covariance matrices are then adjusted during the estimation procedure.

There remains a need in the art for a method for estimating state of charge and state of health of a battery which addresses at least the aforementioned problems.

### SUMMARY OF THE INVENTION

In one aspect of the invention, the present invention is directed at a method for estimating state of charge and state of health of a battery as claimed in Claim 1 of the appended claim set.

The first vector may be a state vector comprising voltage variables and state of charge of the battery.

The second vector may be a parameter vector comprising impedance elements and charge capacity of the battery.

In a further embodiment of the invention, an equivalent circuit corresponding to the first equivalent circuit solver and the second equivalent circuit solver comprises one or more RC elements having a known estimated impedance, and a voltage source representing the open circuit voltage of the cell.

In a further embodiment of the invention, wherein the open circuit voltage of the cell in the equivalent circuit is a non-linear function of the state of the charge of the cell.

In another embodiment, the first state-space filter is a Kalman filter. In an embodiment, the second state-space filter is a Kalman filter. In an embodiment, the electrochemical model is an electrolyte Enhanced Single Particle Model.

In another aspect, the present invention relates to a system for estimating state of charge and state of health of a battery, as claimed in Claim 8 of the appended claim set.

The first vector may be a state vector comprising voltage variables and state of charge of the battery.

The second vector may be a parameter vector comprising impedance elements and charge capacity of the battery.

In a further embodiment of the invention, an equivalent circuit corresponding to the first equivalent circuit solver and the second equivalent circuit solver comprises one or more RC elements having a known estimated impedance, and a voltage source representing the open circuit voltage of the cell.

In a further embodiment of the invention, wherein the open circuit voltage of the cell in the equivalent circuit is a non-linear function of the state of the charge of the cell.

In another embodiment, the first state-space filter is a Kalman filter. In an embodiment, the second state-space filter is a Kalman filter. In an embodiment, the electrochemical model is an electrolyte Enhanced Single Particle Model.

### BRIEF DESCRIPTION OF THE DRAWINGS

Reference will be made to embodiments of the invention, examples of which may be illustrated in accompanying figures. These figures are intended to be illustrative, not limiting. Although the invention is generally described in context of these embodiments, it should be understood that it is not intended to limit the scope of the invention to these particular embodiments.
Figure 1 illustrates a system for estimating state of charge and state of health of a battery, in accordance with an embodiment of the invention.
Figure 2 illustrates a method for estimating state of charge and state of health of a battery, in accordance with an embodiment of the invention.
Figure 3 illustrates an equivalent circuit solver, in accordance with an embodiment of the invention.
Figure 4 illustrates Kalman filter based second vector estimation and eSPM based second vector estimation, with Kalman filter based first vector estimation, in accordance with an embodiment of the invention.
Figure 5 illustrates a 2RC equivalent circuit for the equivalent circuit solver, in accordance with an embodiment of the invention.
Figure 6 illustrates an internal structure of an electrochemical cell and its eSPM equivalent structure, in accordance with an embodiment of the invention.
Figure 7 illustrates a plot of capacitance associated with negative electrode, considering a 2RC model a cell, in accordance with an embodiment of the invention.
Figure 8 illustrates a plot of capacitance associated with positive electrode, considering a 2RC model a cell, in accordance with an embodiment of the invention.

### DETAILED DESCRIPTION OF THE INVENTION

The present invention relates to a method and system for estimating state of charge and state of health of a battery. More particularly, the present invention relates to a method and system for estimating state of charge and state of health of a battery, wherein the battery comprises of one or more electrochemical cells.

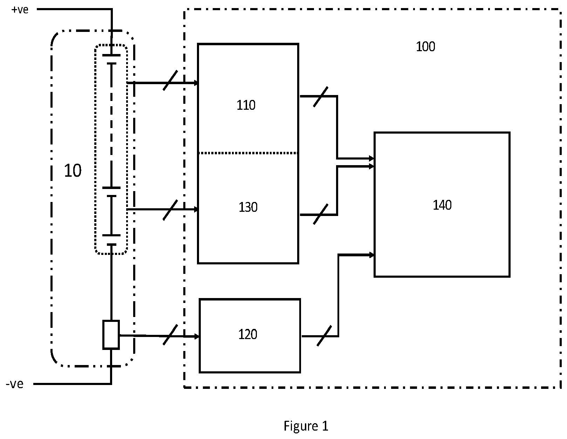

Figure 1 illustrates a system 100 for estimation of state of charge and state of health of a battery 10. The system comprises of a battery pack 10 having one or more cell stacks, a current sensing circuitry 120 for sensing the current passing through cells of the battery 10, a voltage sensing circuitry 110 for sensing the voltage across cells of the battery 10. In an embodiment, each cell stack comprises of a set of cells suitably connected in series and parallel combination. In an embodiment, a cell stack also comprises one or more temperature sensors to get a thermal map of the battery. In the system, the current sensing circuitry 120, the voltage sensing circuitry 110 and a temperature sensing circuitry 130 are coupled to the cell stack and a central processing unit 140.

In an embodiment, measurement of voltage, current and temperature data of the battery 10 is sampled periodically using the relevant sensors integrated into the battery 10. The voltage sensing circuitry 110 is connected to cell terminals to sample cell voltages and the temperature sense circuitry 130 is connected to temperature sensors of the cell stack to sample the temperature data. The current sensing circuitry 120 is configured to sample the current data using current sensors in the battery 10. The central processing unit 140 is configured to estimate the state of charge (SOC) and (SOH) of the cells in the battery 10 as explained hereinbelow.

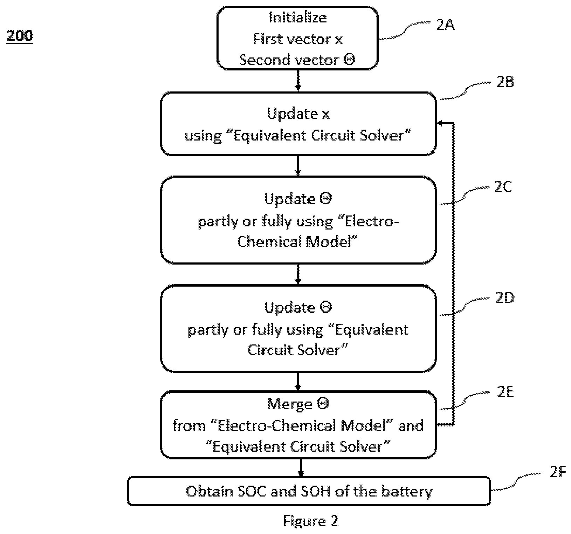

Figure 2 illustrates the method steps involved in a method 200 for estimating state of charge and state of health of the battery 10. At step 2A, a first vector (x) and a second vector (Θ) are initialised, based on typically known values of voltage, state of charge of the battery, impedance and charge capacity (Q) of the battery. In an embodiment, the first vector (x) is a state vector comprising voltage variables and state of charge of the battery 10. In another embodiment, the second vector (Θ) is a parameter vector comprising impedance elements and charge capacity (Q) of the battery.

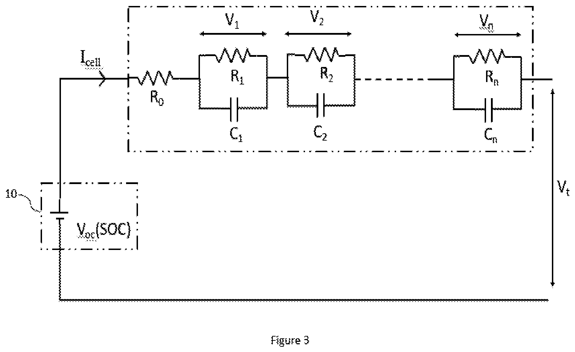

At step 2B, the first vector (x) is estimated and updated by a first state-space filter based equivalent circuit solver by assuming a fixed value of the second vector (Θ). Figure 3 illustrates the underlying first equivalent circuit solver in the present invention. The first equivalent circuit solver comprises one or more RC elements having a known estimated impedance, and a voltage source representing the open circuit voltage of the cell. The impedance of the RC elements is estimated by a second state-space filter based equivalent circuit solver as explained further. It is understood that the voltage across the source (V_{oc}) is a nonlinear function of state of charge where SOC is in turn a function of current 'I_{cell}' and charge capacity (Q). The impedance of the equivalent circuit solver comprises of a plurality of resistance and capacitance (RC) elements. The current I_{cell} and terminal voltage Vₜ depends on the load connected to the cell terminals and both the variables are measured using the current sensing circuitry 120 and the voltage sensing circuitry 110 as shown in Figure 1.

As explained above, the present invention categorizes the variables associated with equivalent circuit solver as illustrated in figure 3, into the state vector (x) and the parameter vector (Θ). As explained above, in an embodiment, the state vector (x) captures the relatively short-term dynamics in the cell, while the parameter vector (Θ) captures the relatively long-term dynamics in the cell. As an example, state vector 'x' is composed of voltage variables V₁ to Vₙ and SOC and parameter vector is composed of impedance elements R₀, R₁ to Rₙ, C₁ to Cₙ and charge capacity Q.

At step 2C, the second vector (Θ) is estimated and updated, fully or partly, based on an Electrochemical Model. At step 2D, the second vector (Θ) is estimated and updated, fully or partly, by a second state-space filter based equivalent circuit solver, which captures the long term effect of load on impedance.

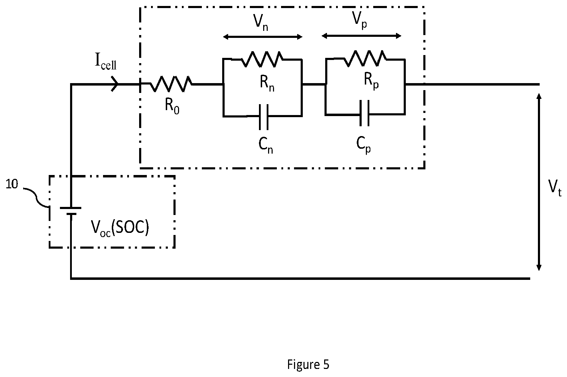

Reference in made to Figure 5 wherein, in the embodiment illustrated, a 2RC equivalent circuit solver of an electrochemical cell (such as lithium-ion cell) where the number of RC components of impedance in Figure 3 is two. Voltage across source indicates the open circuit voltage (V_{OC}) of the cell which is a direct indication of amount of charge present in the cell. The open circuit voltage is represented by V_{oc}, and is a nonlinear function of state of charge. Impedance is characterized by a DC impedance R₀ and two AC impedance components in series. Each AC component is a parallel combination of a resistance R and capacitance C.

The Vₙ and Vₚ in Figure 5 are the voltage drops across the respective RC components. The discharge current 'I_{cell}' in the Figure 5 depicts the direction of flow of current when the circuit terminals are connected to a load.
The voltage and current relation is: ${V}_{t} = Voc \left(SOC\right) - {I}_{cell} ∗ {R}_{0} - {V}_{n} - {V}_{p}$ where *Voc*(*SOC*) is a predetermined function characteristic of cell chemistry and the expressions for *SOC*, *Vₙ, Vₚ* are $SOC = \frac{\int {t}_{cell}}{Q} .$ where Q is the charge storage capacity of the cell. ${\dot{V}}_{n} = \frac{{I}_{cell}}{{C}_{n}} - \frac{{V}_{n}}{{R}_{n} {C}_{n}}$ ${\dot{V}}_{p} = \frac{{I}_{cell}}{{C}_{p}} - \frac{{V}_{p}}{{R}_{p} {C}_{p}}$ This embodiment of the present invention uses the above described 2RC equivalent circuit as the underlying circuit for the equivalent circuit solver.

The state vector 'x' of the first state-space filter is composed of *SOC*, *Vₙ, Vₚ*. Variables *Vₜ, I_{cell}* can be acquired using the current sensing circuitry 120 and the voltage sensing circuitry 110. The other parameters *R*₀, *Rₚ, Rₙ, Cₚ, Cₙ, Q* are the cell parameters that emulate the internal chemical structure and are constituted into parameter vector 'Θ'. Input variables such as *I_{cell}* are constituted into input vector 'U'.

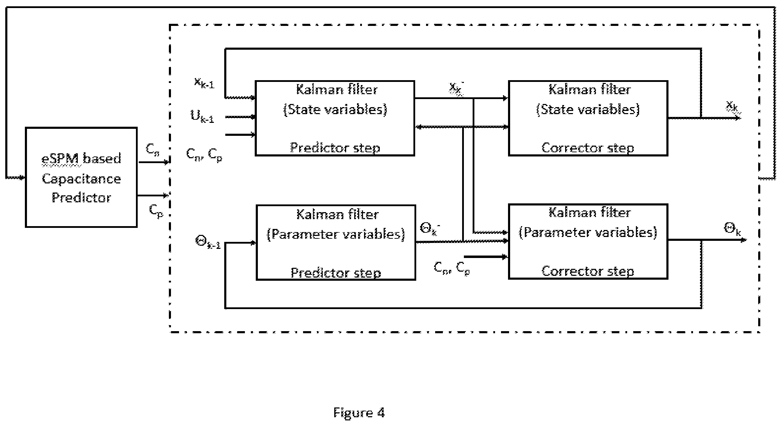

In an embodiment, as referenced in Figure 4, the first state space filter for the equivalent circuit solver and the second state space solver for the equivalent circuit solver is a Kalman Filter. The block level architecture illustrated in Figure 4 illustrates the state-space filters. The first equivalent circuit solver and the second equivalent circuit solver use a Kalman filter which assumes an ageing model such as "Null model" which are known, to predict the cell parameters. In an embodiment, the Kalman filter can be further realized as a Predictor step and a Corrector step. Both the Kalman filters are capable of exchanging information to provide an optimal output.

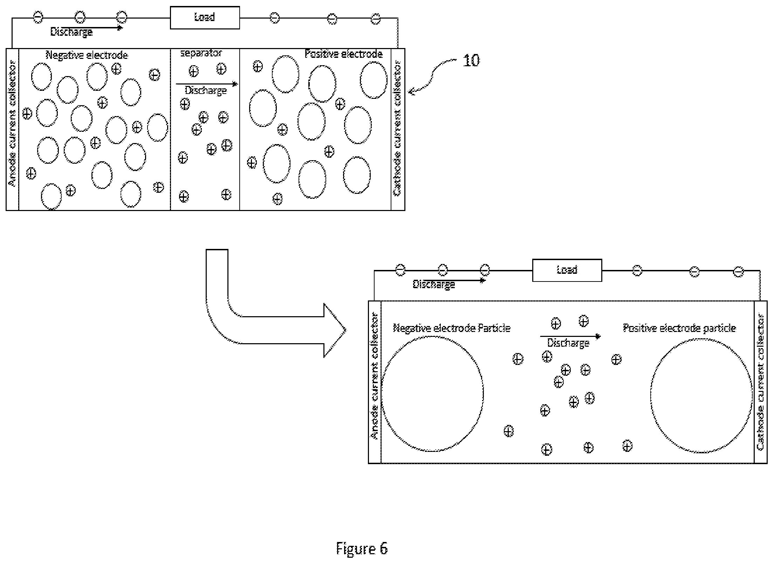

Reference is made to Figure 4 and Figure 6, wherein in an embodiment, the Electrochemical Model referred to in step 2D for estimation and updating of the second vector, is an electrolyte Enhanced Single Particle Model (eSPM). As illustrated in Figure 6, the internal cell structure for an electrolyte Enhanced Single Particle Model, contains a porous negative electrode and a porous positive electrode filled with electrolyte to facilitate positive charge-carrier (eg. lithium ions) mobility. The electrodes are separated using a separator to prevent the flow of electrons while allowing mobility of the positive charge-carriers. The external closed electric circuit with a load facilitates the flow of electrons thus creating a current flow. Each electrode is directly connected to current collectors of high conductivity for electron mobility.

The eSPM equivalent of the cell structure assumes a single spherical structure of electrodes with equivalent concentrations as that of the actual cell. This reduces the structural complexity without significantly compromising on the cell dynamic modelling. The eSPM model also eliminates the separator which has an almost passive role in the ion movement. Electrode current collectors are retained as they are integral for electron movement.

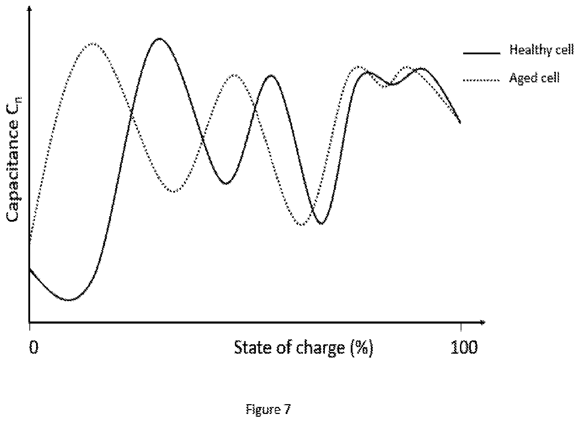

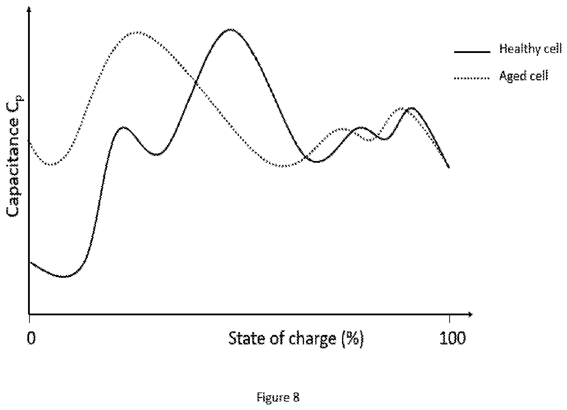

The electrode particle impedance can be approximated to a parallel RC network as shown in figure 5. *Rₙ, Cₙ*, component denotes the negative electrode impedance and *Rₚ*, *Cₚ* that of the positive electrode. The resistance of both the current collectors combined relates to *R*₀. The Electrochemical Model based on eSPM model estimates the *Cₙ, Cₚ* parameters as a function of variables comprising SOC and charge capacity Q. This uses internal cell diffusion concept which drives the flow of positive charge-carriers (eg. lithium ions) between the single particle electrodes. Figure 7 depicts a typical plot of *Cₙ* as a function of SOC and Figure 8 depicts a typical plot of *Cₚ* as a function of SOC. Both the plots show variation as the charge capacity (Q) of the cell keeps deteriorating as the cell keeps ageing. Updating 'Θ' based on the eSPM model predicts the *Cₙ, Cₚ* values based on the input SOC and 'Θ' parameter.

At step 2E, the updated values of the second vector (Θ) by the Electrochemical Model and the second state-space filter based equivalent circuit solver as explained above are merged to result in a more accurate estimation of second vector (Θ). Finally at step 2F, the state of charge of the battery is obtained from the updated value of the first vector (x), and the state of the health of the battery is obtained from the merged and updated value of the second vector (Θ), as explained above.

Advantageously, the present invention provides a method for estimation of state of charge and state of health of the battery which benefits from the simplicity of equivalent circuit models, while also benefiting from the accuracy of Electrochemical models.

Further, the system and method of the present invention are capable of being integrated in a battery management system for an electric or a hybrid vehicle, thereby providing a system for estimation of state of charge and state of health of a battery, which is not only highly accurate, but is also less computationally intensive. An accurate prediction of state of charge of a battery indicates to the user as to when the battery needs to be charged and the range of the electric vehicle, and the accurate prediction of state of health of a battery indicates to the user as to when the battery needs to be replaced.

While the present invention has been described with respect to certain embodiments, it will be apparent to those skilled in the art that various changes and modification may be made without departing from the scope of the invention as defined in the following claims.

## Claims

1. . A method (200) for estimating state of charge and state of health of a battery (10), the method (200) being performed by a central processing unit (140), and comprising the steps of:
initialising a first vector (x) and a second vector (Θ) based on typically known values of voltage, state of charge of the battery, impedance and charge capacity (Q) of the battery (10);
estimating and updating the first vector (x) by a first state-space filter based first equivalent circuit solver by assuming a fixed value of the second vector (Θ);
estimating and updating the second vector (Θ), fully or partly, based on an Electrochemical Model;
estimating and updating the second vector (Θ), fully or partly, by a second state-space filter based second equivalent circuit solver;
merging the updated values of the second vector (Θ) by the Electrochemical Model and the second state-space filter based equivalent circuit solver; and
obtaining the state of charge of the battery (10) from the updated value of the first vector (x), and obtaining the state of the health of the battery (10) from the merged and updated value of the second vector (Θ).

2. . The method (200) as claimed in claim 1, wherein the first vector (x) is a state vector comprising voltage variables and state of charge of the battery (10).

3. . The method (200) as claimed in claim 1, wherein the second vector (Θ) is a parameter vector comprising impedance elements and charge capacity (Q) of the battery (10).

4. . The method (200) as claimed in claim 1, wherein an equivalent circuit corresponding to the first equivalent circuit solver and the second equivalent circuit solver comprises one or more RC elements having a known estimated impedance, and a voltage source representing the open circuit voltage (V_{oc}) of a cell.

5. . The method (200) as claimed in claim 4, wherein the open circuit voltage (V_{oc}) of the cell in the equivalent circuit is a non-linear function of the state of the charge of the cell.

6. . The method (200) as claimed in claim 1, wherein the first state-space filter is a Kalman filter and the second state-space filter is another Kalman filter.

7. . The method (200) as claimed in claim 1, wherein the electrochemical model is an electrolyte Enhanced Single Particle Model.

8. . A system (100) for estimating state of charge and state of health of a battery (10), comprising:
a voltage sensing circuitry (110) for sensing the voltage across cells of the battery (10);
a current sensing circuitry (120) for sensing the current passing through cells of the battery (10); and
a central processing unit (140) configured for initialising a first vector (x) and a second vector (Θ) based on typically known values of voltage, state of charge of the battery (10), impedance and charge capacity (Q) of the battery (10), estimating and updating the first vector (x) by a first state-space filter based first equivalent circuit solver by assuming a fixed value of the second vector, estimating and updating the second vector (Θ), fully or partly, based on an Electrochemical Model, estimating and updating the second vector (Θ), fully or partly, by a second state-space filter based second equivalent circuit solver, merging the updated values of the second vector (Θ) by the Electrochemical Model and the second state-space filter based equivalent circuit solver, and obtaining the state of charge of the battery (10) from the updated value of the first vector (x), and obtaining the state of the health of the battery (10) from the merged and updated value of the second vector (Θ).

9. . The system (100) as claimed in claim 8, wherein the first vector (x) is a state vector comprising voltage variables and state of charge of the battery (10).

10. . The system (100) as claimed in claim 8, wherein the second vector (Θ) is a parameter vector comprising impedance elements and charge capacity (Q) of the battery (10).

11. . The system (100) as claimed in claim 8, wherein an equivalent circuit corresponding to the first equivalent circuit solver and the second equivalent circuit solver comprises one or more RC elements having a known estimated impedance, and a voltage source representing the open circuit voltage (V_{oc}) of a cell.

12. . The system (100) as claimed in claim 11, wherein the open circuit voltage (V_{oc}) of the cell in the equivalent circuit is a non-linear function of the state of the charge of the cell.

13. . The system (100) as claimed in claim 8, wherein the first state-space filter is a Kalman filter.

14. . The system (100) as claimed in claim 8, wherein the second state-space filter is a Kalman filter.

15. . The system (100) as claimed in claim 8, wherein the electrochemical model is electrolyte Enhanced Single Particle Model.

## Patentansprüche

1. Verfahren (200) zum Schätzen eines Ladezustands und eines Gesundheitszustands einer Batterie (10), wobei das Verfahren (200) durch eine zentrale Verarbeitungseinheit (140) durchgeführt wird und die folgenden Schritte umfasst:
Initialisieren eines ersten Vektors (x) und eines zweiten Vektors (Θ) basierend auf typischerweise bekannten Werten von Spannung, Ladezustand der Batterie, Impedanz und Ladekapazität (Q) der Batterie (10);
Schätzen und Aktualisieren des ersten Vektors (x) durch einen auf einem ersten Zustandsraumfilter basierenden ersten Ersatzschaltungslöser durch Annehmen eines festen Werts des zweiten Vektors (Θ);
Schätzen und Aktualisieren des zweiten Vektors (Θ) ganz oder teilweise basierend auf einem elektrochemischen Modell;
Schätzen und Aktualisieren des zweiten Vektors (Θ) ganz oder teilweise durch einen auf einem zweiten Zustandsraumfilter basierenden zweiten Ersatzschaltungslöser;
Zusammenführen der aktualisierten Werte des zweiten Vektors (Θ) durch das elektrochemische Modell und den auf dem zweiten Zustandsraumfilter basierenden Ersatzschaltungslöser; und
Erlangen des Ladezustands der Batterie (10) aus dem aktualisierten Wert des ersten Vektors (x) und Erlangen des Gesundheitszustands der Batterie (10) aus dem zusammengeführten und aktualisierten Wert des zweiten Vektors (Θ).

2. Verfahren (200) nach Anspruch 1, wobei der erste Vektor (x) ein Zustandsvektor ist, der Spannungsvariablen und einen Ladezustand der Batterie (10) umfasst.

3. Verfahren (200) nach Anspruch 1, wobei der zweite Vektor (Θ) ein Parametervektor ist, der Impedanzelemente und eine Ladekapazität (Q) der Batterie (10) umfasst.

4. Verfahren (200) nach Anspruch 1, wobei eine Ersatzschaltung, die dem ersten Ersatzschaltungslöser und dem zweiten Ersatzschaltungslöser entspricht, ein oder mehrere RC-Elemente, die eine bekannte geschätzte Impedanz aufweisen, und eine Spannungsquelle, welche die Leerlaufspannung (V_{oc}) einer Zelle darstellt, umfasst.

5. Verfahren (200) nach Anspruch 4, wobei die Leerlaufspannung (V_{oc}) der Zelle in der Ersatzschaltung eine nichtlineare Funktion des Ladezustands der Zelle ist.

6. Verfahren (200) nach Anspruch 1, wobei das erste Zustandsraumfilter ein Kalman-Filter ist und das zweite Zustandsraumfilter ein anderes Kalman-Filter ist.

7. Verfahren (200) nach Anspruch 1, wobei das elektrochemische Modell ein erweitertes Einteilchenmodell für Elektrolyte ist.

8. System (100) zum Schätzen eines Ladezustands und eines Gesundheitszustands einer Batterie (10), umfassend:
eine Spannungserfassungsschaltung (110) zum Erfassen der Spannung über Zellen der Batterie (10);
eine Stromerfassungsschaltung (120) zum Erfassen des Stroms, der durch Zellen der Batterie (10) fließt; und
eine zentrale Verarbeitungseinheit (140), die zu Folgendem konfiguriert ist: Initialisieren eines ersten Vektors (x) und eines zweiten Vektors (Θ) basierend auf typischerweise bekannten Werten von Spannung, Ladezustand der Batterie (10), Impedanz und Ladekapazität (Q) der Batterie (10), Schätzen und Aktualisieren des ersten Vektors (x) durch einen auf einem ersten Zustandsraumfilter basierenden ersten Ersatzschaltungslöser durch Annehmen eines festen Werts des zweiten Vektors, Schätzen und Aktualisieren des zweiten Vektors (Θ) ganz oder teilweise basierend auf einem elektrochemischen Modell, Schätzen und Aktualisieren des zweiten Vektors (Θ) ganz oder teilweise durch einen auf einem zweiten Zustandsraumfilter basierenden zweiten Ersatzschaltungslöser, Zusammenführen der aktualisierten Werte des zweiten Vektors (Θ) durch das elektrochemische Modell und den auf dem zweiten Zustandsraumfilter basierenden Ersatzschaltungslöser und Erlangen des Ladezustands der Batterie (10) aus dem aktualisierten Wert des ersten Vektors (x) und Erlangen des Gesundheitszustands der Batterie (10) aus dem zusammengeführten und aktualisierten Wert des zweiten Vektors (Θ).

9. System (100) nach Anspruch 8, wobei der erste Vektor (x) ein Zustandsvektor ist, der Spannungsvariablen und einen Ladezustand der Batterie (10) umfasst.

10. System (100) nach Anspruch 8, wobei der zweite Vektor (Θ) ein Parametervektor ist, der Impedanzelemente und eine Ladekapazität (Q) der Batterie (10) umfasst.

11. System (100) nach Anspruch 8, wobei eine Ersatzschaltung, die dem ersten Ersatzschaltungslöser und dem zweiten Ersatzschaltungslöser entspricht, ein oder mehrere RC-Elemente, die eine bekannte geschätzte Impedanz aufweisen, und eine Spannungsquelle, welche die Leerlaufspannung (V_{oc}) einer Zelle darstellt, umfasst.

12. System (100) nach Anspruch 11, wobei die Leerlaufspannung (V_{oc}) der Zelle in der Ersatzschaltung eine nichtlineare Funktion des Ladezustands der Zelle ist.

13. System (100) nach Anspruch 8, wobei das erste Zustandsraumfilter ein Kalman-Filter ist.

14. System (100) nach Anspruch 8, wobei das zweite Zustandsraumfilter ein Kalman-Filter ist.

15. System (100) nach Anspruch 8, wobei das elektrochemische Modell erweitertes Einteilchenmodell für Elektrolyte ist.

## Revendications

1. Procédé (200) pour estimer l'état de charge et l'état de santé d'une batterie (10), le procédé (200) étant réalisé par une unité centrale de traitement (140), et comprenant les étapes suivantes :
l'initialisation d'un premier vecteur (x) et d'un second vecteur (Θ) sur la base de valeurs typiquement connues de tension, d'état de charge de la batterie, d'impédance et de capacité de charge (Q) de la batterie (10) ;
l'estimation et la mise à jour du premier vecteur (x) par un premier solveur de circuit équivalent basé sur un premier filtre d'espace d'état en supposant une valeur fixe du second vecteur (Θ) ;
l'estimation et la mise à jour du second vecteur (Θ), totalement ou partiellement, sur la base d'un modèle électrochimique ;
l'estimation et la mise à jour du second vecteur (Θ), totalement ou partiellement, par un second solveur de circuit équivalent basé sur un second filtre d'espace d'état ;
la fusion des valeurs mises à jour du second vecteur (Θ) par le modèle électrochimique et le solveur de circuit équivalent basé sur un second filtre d'espace d'état ; et
l'obtention de l'état de charge de la batterie (10) à partir de la valeur mise à jour du premier vecteur (x), et l'obtention de l'état de santé de la batterie (10) à partir de la valeur fusionnée et mise à jour du second vecteur (Θ).

2. Procédé (200) selon la revendication 1, dans lequel le premier vecteur (x) est un vecteur d'état comprenant des variables de tension et l'état de charge de la batterie (10).

3. Procédé (200) selon la revendication 1, dans lequel le second vecteur (Θ) est un vecteur de paramètre comprenant des éléments d'impédance et une capacité de charge (Q) de la batterie (10).

4. Procédé (200) selon la revendication 1, dans lequel un circuit équivalent correspondant au premier solveur de circuit équivalent et au second solveur de circuit équivalent comprend un ou plusieurs éléments RC ayant une impédance estimée connue, et une source de tension représentant la tension en circuit ouvert (V_{oc}) d'une cellule.

5. Procédé (200) selon la revendication 4, dans lequel la tension en circuit ouvert (V_{oc}) de la cellule dans le circuit équivalent est une fonction non linéaire de l'état de charge de la cellule.

6. Procédé (200) selon la revendication 1, dans lequel le premier filtre d'espace d'état est un filtre de Kalman et le second filtre d'espace d'état est un autre filtre de Kalman.

7. Procédé (200) selon la revendication 1, dans lequel le modèle électrochimique est un modèle à particule unique amélioré par électrolyte.

8. Système (100) pour estimer l'état de charge et l'état de santé d'une batterie (10), comprenant :
une circuiterie de détection de tension (110) pour détecter la tension aux bornes des cellules de la batterie (10) ;
une circuiterie de détection de courant (120) pour détecter le courant traversant les cellules de la batterie (10) ; et
une unité centrale de traitement (140) configurée pour l'initialisation d'un premier vecteur (x) et d'un second vecteur (Θ) sur la base de valeurs typiquement connues de tension, d'état de charge de la batterie (10), d'impédance et de capacité de charge (Q) de la batterie (10), l'estimation et la mise à jour du premier vecteur (x) par un premier solveur de circuit équivalent basé sur un premier filtre d'espace d'état en supposant une valeur fixe du second vecteur, l'estimation et la mise à jour du second vecteur (Θ), totalement ou partiellement, sur la base d'un modèle électrochimique, l'estimation et la mise à jour du second vecteur (Θ), totalement ou partiellement, par un second solveur de circuit équivalent basé sur un second filtre d'espace d'état, la fusion des valeurs mises à jour du second vecteur (Θ) par le modèle électrochimique et le solveur de circuit équivalent basé sur un second filtre d'espace d'état, et l'obtention de l'état de charge de la batterie (10) à partir de la valeur mise à jour du premier vecteur (x), et l'obtention de l'état de santé de la batterie (10) à partir de la valeur fusionnée et mise à jour du second vecteur (Θ).

9. Système (100) selon la revendication 8, dans lequel le premier vecteur (x) est un vecteur d'état comprenant des variables de tension et l'état de charge de la batterie (10).

10. Système (100) selon la revendication 8, dans lequel le second vecteur (Θ) est un vecteur de paramètre comprenant des éléments d'impédance et une capacité de charge (Q) de la batterie (10).

11. Système (100) selon la revendication 8, dans lequel un circuit équivalent correspondant au premier solveur de circuit équivalent et au second solveur de circuit équivalent comprend un ou plusieurs éléments RC ayant une impédance estimée connue, et une source de tension représentant la tension en circuit ouvert (V_{oc}) d'une cellule.

12. Système (100) selon la revendication 11, dans lequel la tension en circuit ouvert (V_{oc}) de la cellule dans le circuit équivalent est une fonction non linéaire de l'état de charge de la cellule.

13. Système (100) selon la revendication 8, dans lequel le premier filtre d'espace d'état est un filtre de Kalman.

14. Système (100) selon la revendication 8, dans lequel le second filtre d'espace d'état est un filtre de Kalman.

15. Système (100) selon la revendication 8, dans lequel le modèle électrochimique est un modèle à particule unique amélioré par électrolyte.
